# FASCICULE DE BREVET EUROPEEN

(11) **EP 4 006 997 B1**
(45) Date de publication et mention de la délivrance du brevet: **25.10.2023**
(21) Numéro de dépôt: 21209987.3
(22) Date de dépôt: 23.11.2021
(51) Int. Cl.: H10N 60/01, H10N 60/10, G06N 10/00

(54) **PROCÉDÉ DE RÉALISATION D'UN DISPOSITIF QUANTIQUE**
VERFAHREN ZUR HERSTELLUNG EINER QUANTENVORRICHTUNG
METHOD FOR MANUFACTURING A QUANTUM DEVICE

(30) Priorité: 27.11.2020 FR 2012305
(43) Date de publication de la demande: 01.06.2022
(73) Titulaire: Commissariat à l'Energie Atomique et aux Energies Alternatives, 75015 Paris (FR)
(72) Inventeur: POSSEME, Nicolas, 38054 GRENOBLE Cedex 09 (FR); HUTIN, Louis, 38054 GRENOBLE Cedex 09 (FR); LE ROYER, Cyrille, 38054 GRENOBLE Cedex 09 (FR); LEFLOCH, François, 38054 GRENOBLE Cedex 09 (FR); NEMOUCHI, Fabrice, 38054 GRENOBLE Cedex 09 (FR); VINET, Maud, 38054 GRENOBLE Cedex 09 (FR)
(74) Mandataire: Hautier IP

(56) Documents cités:
- FR-A1- 3 088 483
- US-A1- 2020 279 937

## Description

### DOMAINE TECHNIQUE

La présente invention concerne le domaine de l'électronique quantique. Elle trouve pour application particulièrement avantageuse la réalisation de grilles supraconductrices dans des dispositifs quantiques à bits quantiques (appelés quantum bits ou qubits), notamment pour des dispositifs basés sur des architectures à qubits de spin ou à qubits supraconducteurs

### ETAT DE LA TECHNIQUE

Dans le domaine de l'électronique quantique, un bit quantique ou qubit correspond à un état quantique qui représente la plus petite unité de stockage d'information quantique. Cet état quantique est caractérisé par la superposition quantique de plusieurs états, notamment de l'état 0 et de l'état 1. En pratique le bit quantique peut être obtenu par différents dispositifs basés sur différentes architectures. Ainsi, il existe des qubits liés à un état quantique :
- d'un porteur de charge, par exemple le spin d'un électron ou d'un trou (qubit de spin),
- d'un courant circulant dans un supraconducteur, par exemple sa phase (qubit supraconducteur),
- d'un ion piégé ou d'un atome ou d'une molécule, par exemple son niveau énergétique,
- d'un photon, par exemple sa polarisation (qubit photonique).

Chaque type de dispositif possède des avantages intrinsèques et des inconvénients distincts. Par exemple, les dispositifs quantiques à qubits supraconducteurs permettent notamment d'obtenir une bonne intrication entre qubits. Cependant, ces dispositifs présentent encore une trop grande variabilité. Ils sont notamment sensibles aux petites imperfections induites par les procédés de fabrication. Ils requièrent notamment une interface de très grande qualité entre les deux réservoirs supraconducteurs, pour obtenir un effet Josephson. Il est également difficile de former un qubit unitaire via ces dispositifs.

Les dispositifs quantiques à qubits de spin peuvent fonctionner avec un nombre plus faible de qubits, et consommer moins d'énergie. Ils peuvent également bénéficier des procédés de fabrication et des technologies de la microélectronique pour améliorer la reproductibilité et augmenter la densité d'intégration de ces dispositifs à qubits de spin.

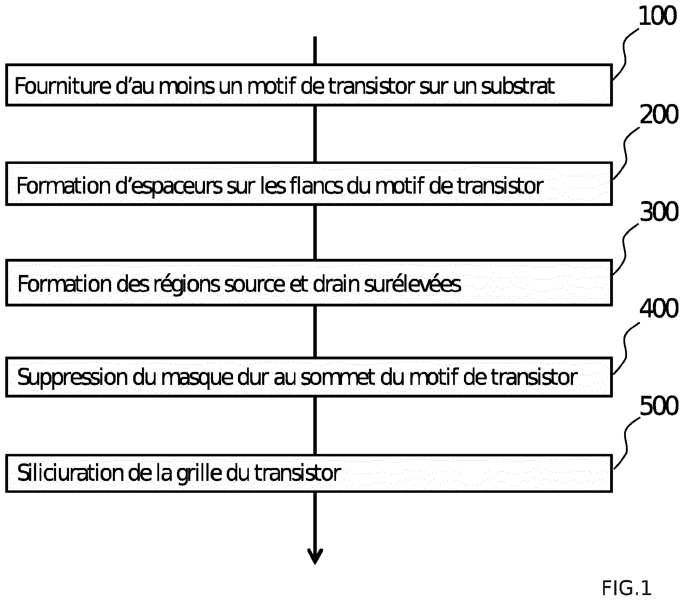

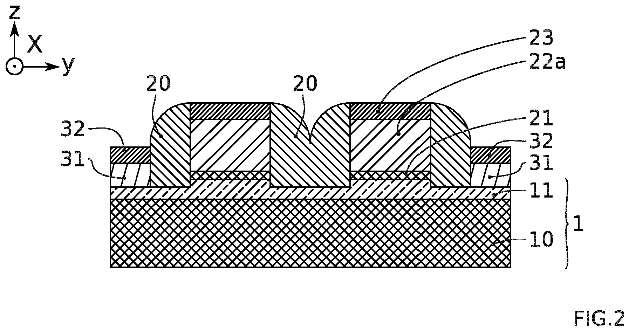

Le document « SOI technology for quantum information processing » de S. De Franceschi et al., Electron Devices Meeting (IEDM), 2016 IEEE International, pp. 13.4.1 - 13.4.4, décrit un dispositif quantique à qubits de spin réalisé selon un procédé de fabrication dérivé des technologies de transistors à canal totalement déplété (FDSOI). La figure 1 présente certaines étapes standard de fabrication d'un tel dispositif. Un ou plusieurs motifs de transistors comprenant chacun une grille et un diélectrique de grille sont formés 100 sur un substrat SOI. Des espaceurs sont ensuite formés 200 de part et d'autre des motifs de grille. Les régions de source et de drain surélevées sont formées 300 par épitaxie au bord et autour des espaceurs extérieurs. Après retrait 400 du masque dur sur le sommet de la grille, la grille est siliciurée 500. Ce procédé permet notamment de réaliser un dispositif quantique à deux qubits en série, dans une zone active 11 d'un substrat SOI 1, comme illustré à la figure 2. Les deux grilles 22a permettent de commander ces deux qubits. Les régions 31 de source et de drain forment des réservoirs de porteurs de charge pour ces deux qubits. Un tel dispositif quantique à qubits de spin présente néanmoins une vitesse de fonctionnement inférieure à celle d'un dispositif à qubits supraconducteurs. Ces limitations sont dues en partie au procédé de réalisation de ce dispositif. Un exemple de l'art antérieur se trouve dans le brevet FR3088483. Le document a trait au domaine des transistors et plus particulièrement à celui de la mise en oeuvre de transistors dotés de zones de source et de drain à base d'un composé de métal et de semiconducteur. Il s'applique notamment à la réalisation de transistors dotés de zones de source et de drain en matériau susceptible d'avoir des propriétés supraconductrices.

Un objet de la présente invention est de pallier au moins en partie certains des inconvénients mentionnés ci-dessus.

En particulier, un objet de la présente invention est de proposer un procédé de réalisation d'un dispositif quantique diminuant la consommation d'énergie tout en améliorant la vitesse de fonctionnement.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, un premier aspect de l'invention concerne un procédé de réalisation d'un dispositif quantique comprenant les étapes suivantes :
- Fournir un substrat présentant une face avant et portant au moins un motif de transistor sur sa face avant,
   Ledit motif de transistor comprenant, en empilement :
   - un diélectrique de grille sur la face avant du substrat,
   - une grille sur le diélectrique de grille, ladite grille présentant un sommet et des flancs,
- Former une couche de protection au niveau de la face avant du substrat, ladite couche de protection étant configurée pour empêcher une diffusion (ou la réaction) d'au moins une espèce métallique dans le substrat,
- Former une couche métallique à base d'au moins une espèce métallique au moins sur les flancs de la grille,
- Former une région supraconductrice dans la grille, par diffusion latérale de l'au moins une espèce métallique à partir des flancs de ladite grille.

Ainsi, il est notamment possible de réaliser un dispositif quantique à qubits de spin d'électrons. Un tel dispositif nécessite en effet une modulation de champ magnétique. La région supraconductrice formée dans la grille du motif de transistor permet avantageusement de générer et moduler un champ magnétique compatible avec le contrôle de qubits de spin d'électrons.

Les procédés existants mettent généralement en oeuvre une étape de siliciuration de la grille à partir du sommet. Cela n'est pas adapté au contrôle de spin. Lors du développement de la présente invention, il est apparu qu'un bon contrôle de spin nécessitait la formation d'une région supraconductrice au plus près du canal, juste au-dessus du diélectrique de grille. Contrairement aux procédés de l'art antérieur, le procédé selon l'invention permet de former une telle région supraconductrice, par diffusion latérale à partir des flancs de la grille.

Cette diffusion latérale est effectuée à partir de la couche métallique. Cette couche métallique comprend au moins une espèce métallique apte à former un alliage ou un composé supraconducteur par réaction après diffusion au sein de la grille. Dans ce cas la diffusion est appelée diffusion réactive. Selon une possibilité, l'espèce métallique est supraconductrice avant réaction et diffuse simplement au sein de la grille.

Pour empêcher la diffusion de l'au moins une espèce métallique dans le substrat, une couche de protection est avantageusement formée au niveau de la face avant du substrat.

La couche de protection peut ainsi empêcher la diffusion d'espèces métalliques à partir d'une couche métallique en surface du substrat, par exemple déposée par un dépôt conforme. La couche de protection peut également empêcher la diffusion ou la réaction en surface du substrat avec des espèces métalliques provenant de résidus métalliques formés à l'issue de la diffusion latérale à partir des flancs de la grille.

Le procédé selon l'invention permet ainsi de réaliser un dispositif quantique présentant une architecture de transistor à grille supraconductrice.

Cela permet de réaliser un dispositif quantique à qubits de spin d'électrons présentant une vitesse de fonctionnement améliorée. La région supraconductrice formée par le procédé selon l'invention permet également de diminuer la consommation d'énergie du dispositif lors des opérations sur les qubits.

Il est également possible de réaliser un dispositif quantique à qubits supraconducteurs par le procédé selon l'invention. Un tel dispositif bénéficie dès lors des avantages liés à la mise en oeuvre du procédé via les technologies de l'industrie microélectronique. En particulier, la densité d'intégration d'un tel dispositif peut être augmentée.

Selon un aspect séparable, l'invention concerne aussi un dispositif quantique présentant une architecture de transistor à grille supraconductrice tel qu'obtenu par le procédé selon l'invention.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels /
La figure 1 présente un diagramme illustrant des étapes de réalisation d'un transistor selon un procédé de l'art antérieur.
La figure 2 présente schématiquement un dispositif quantique selon l'art antérieur obtenu à partir du procédé de réalisation de la figure 1.
La figure 3 présente un diagramme illustrant des étapes de réalisation d'un dispositif quantique selon un premier mode de réalisation du procédé selon la présente invention.
Les figures 4A à 4J illustrent schématiquement des étapes de formation d'un dispositif quantique selon un premier mode de réalisation du procédé selon la présente invention.
La figure 5 présente un diagramme illustrant des étapes de réalisation d'un dispositif quantique selon un deuxième mode de réalisation du procédé selon la présente invention
Les figures 6A à 6J illustrent schématiquement des étapes de formation d'un dispositif quantique selon un deuxième mode de réalisation du procédé selon la présente invention.
La figure 7A présente schématiquement un dispositif quantique obtenu à partir d'un troisième mode de réalisation du procédé selon la présente invention.
La figure 7B présente schématiquement un dispositif quantique obtenu à partir d'un quatrième mode de réalisation du procédé selon la présente invention.
La figure 7C présente schématiquement un dispositif quantique obtenu à partir d'un cinquième mode de réalisation du procédé selon la présente invention.
Les figures 8A à 8F illustrent schématiquement des étapes de formation de dispositifs quantiques et de transistors en co-intégration, selon un mode de réalisation du procédé selon la présente invention.
Les figures 9A à 9D illustrent schématiquement des étapes de formation de dispositifs quantiques et de transistors en co-intégration, selon un autre mode de réalisation du procédé selon la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches, portions et éléments du dispositif (par exemple espaceur, couche active, couche de protection, région source/drain, grille, masque dur) ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le motif de transistor fourni comprend en outre un masque dur sur le sommet de la grille, ledit masque dur étant configuré pour empêcher une diffusion d'au moins une espèce métallique dans la grille à partir dudit sommet, de sorte que la formation de la région supraconductrice se fait uniquement par diffusion latérale à partir des flancs de la grille. Cela permet d'obtenir un front de diffusion relativement plan progressant depuis chacun des flancs jusque vers un plan médian au centre de la grille. Cela améliore la qualité de la région supraconductrice ainsi formée.

Selon un exemple, la couche métallique formée comprend au moins une espèce métallique parmi du cobalt, du platine et du vanadium.

Selon un exemple, la couche métallique est formée par dépôt conforme de métal sur le motif de transistor et sur la couche de protection en face avant du substrat.

Selon un exemple, la couche métallique est formée par dépôt CVD (acronyme de Chemical Vapor Déposition) ou par dépôt ALD (acronyme de Atomic Layer Déposition). Cela permet de déposer l'au moins une espèce métallique sur les flancs de la grille.

Selon un exemple, la couche métallique est formée par dépôt PVD (acronyme de Physical Vapor Déposition) avec des conditions permettant un redépôt ou une repulvérisation (couramment appelé « sputtering » ou « resputtering ») depuis le fond des motifs vers les flancs de la grille, typiquement par traitement plasma. Selon un exemple, la couche métallique est formée par dépôt PVD peu directionnel. Cela permet de déposer l'au moins une espèce métallique sur les flancs de la grille.

Selon un exemple, la diffusion latérale est configurée pour propager l'au moins une espèce métallique depuis chacun des flancs de la grille au moins jusqu'au centre de la grille, de façon à ce que la région supraconductrice soit formée sur toute une largeur L_{g} de la grille. La grille est ainsi totalement supraconductrice. Cela améliore le contrôle du dispositif quantique ainsi formé.

Selon un exemple, la grille présente une largeur L_{g} ≤ 40 nm, de préférence L_{g} ≤ 30 nm, de préférence L_{g} ≤ 25 nm, de préférence L_{g} ≤ 20 nm. Cela permet de réduire le nombre de qubits intriqués dans le dispositif.

Selon un exemple, la grille présente une largeur L_{g} et la couche métallique formée présente une épaisseur eₘ ≥ L_{g}/5. Cela permet d'avoir une quantité suffisante d'espèces métalliques dans la couche métallique, de sorte que toute la grille puisse être rendue supraconductrice à l'issue de la diffusion latérale. L'épaisseur eₘ peut également dépendre du métal utilisé et/ou de la nature de la grille.

Selon un exemple, la diffusion latérale se fait par recuit thermique, par exemple par recuit de type RCA (acronyme de Rapid Thermal Annealing). Les conditions de diffusion latérale ou de siliciuration latérale peuvent notamment dépendre du métal utilisé et de la phase visée. Le tableau ci-dessous donne des exemples de rapport d'épaisseur entre différents métaux (le Co, Pt et V) et le silicium. L'ambiance de recuit peut être sous gaz inerte Ar, He ou N₂.

| Métal (nm) | Silicium (nm) | Siliciure formé (nm) | Game de T°C *Game avantageuse* | Game de temps *Game avantageuse* | Recuit sous Ar, He |
|---|---|---|---|---|---|
| Pt | Si | PtSi | 400°C à 700°C | 10s à 300s | 1 seul recuit de type RTA |
| 1.00 | 1.35 | 1.98 | *450°C à 550°C* | *60s* à *120s* | |
| 2 Co | Si | Co₂Si | 550°C à 900°C | 10s à 300s | 2 étapes de recuit de type RTA |
| 1.00 | 0.91 | 1.47 | *600°C à 800°C* | *60s* à *120s* | |
| V | Si | V3Si | 600°C à 1000°C | 10s à 1000s | 1 seul recuit de type RTA |
| 1.00 | 0.48 | 1.26 | *750°C à 850°C* | *60s à 500s* | |

Dans le cas d'une siliciuration latérale, l'épaisseur de Si consommé est de préférence inférieure ou égale à la moitié de la largeur de grille. Cela permet d'éviter de former une zone supraconductrice polyphasée.

Selon un exemple, la couche de protection formée au niveau de la face avant du substrat présente une épaisseur e'ₛ supérieure ou égale à 2 nm lors de la formation de la région supraconductrice. Cela permet d'améliorer l'étanchéité de la couche de protection vis-à-vis de la diffusion d'espèces métalliques.

Selon un exemple, la formation de la couche de protection comprend les sous-étapes suivantes :
- Oxyder de façon différenciée la face avant du substrat et les flancs de la grille, de sorte que l'épaisseur ef d'oxyde formé au niveau des flancs de la grille soit strictement inférieure à l'épaisseur es d'oxyde formé au niveau de la face avant du substrat, tel que ef ≤ k.es avec k ≤ 0,8 et de préférence k ≤ 0,5,
- Retirer l'oxyde formé au niveau des flancs de la grille, ledit retrait étant configuré pour conserver au moins en partie l'oxyde formé au niveau de la face avant du substrat.
- Une telle oxydation différenciée est facilement maîtrisable.

Selon un exemple, l'oxydation différenciée est réalisée à partir d'au moins un plasma comprenant des espèces à base d'oxygène et des espèces à base d'hydrogène.

Selon un exemple, les espèces à base d'hydrogène sont prises parmi le dihydrogène H2, l'ammoniac NH3, l'hydrure de bore HBr.

Selon un exemple, l'au moins un plasma comprend :
- un premier plasma anisotrope à base d'hydrogène principalement dirigé selon une direction normale à la face avant du substrat, ledit premier plasma étant configuré pour modifier une portion de substrat sur une profondeur ds à partir de la face avant, et pour modifier une portion de grille sur une largeur df à partir des flancs, avec df ≤ k.ds avec k ≤ 0,8 et de préférence k ≤ 0,5,
- un deuxième plasma à base d'oxygène configuré pour oxyder les portions de substrat et de grille modifiées.
Les portions de substrat et de grille sont ainsi modifiées puis oxydées séquentiellement. Cela permet d'améliorer le contrôle de l'oxydation différenciée, notamment selon la profondeur ds et l'épaisseur df.

Selon un exemple, le premier plasma succède au deuxième plasma.

Selon un exemple, le premier plasma est un plasma d'hydrogène H2 et le deuxième plasma est un plasma d'oxygène O2.

Selon un exemple, les premier et deuxième plasmas sont effectués simultanément à partir d'une chimie de plasma HBr/O2. Cela permet de diminuer le nombre d'étapes. Une chimie de plasma HBr/O2 peut en outre être utilisée pour graver et former le motif de transistor. Les étapes de fourniture du motif de transistor et de formation de la couche de protection peuvent dès lors être en partie fusionnées.

Selon un exemple, le retrait de l'oxyde formé au niveau des flancs de la grille se fait par gravure humide.

Selon un exemple, la formation de la couche de protection comprend les sous-étapes suivantes :
- Déposer un oxyde sur la face avant du substrat et sur les flancs de la grille,
- Retirer en partie l'oxyde déposé de sorte à conserver une couche d'oxyde sur la face avant du substrat, ladite couche d'oxyde présentant une épaisseur es supérieure ou égale à l'épaisseur eg du diélectrique de grille du motif de transistor.
Cela permet d'éviter la formation ultérieure d'un retrait de matière, encore appelé recess selon la terminologie anglo-saxonne couramment utilisée, dans le substrat.

Selon un exemple, les flancs de la grille sont exposés sur au moins 90% de leur hauteur h_{g}, à l'issue du retrait de l'oxyde déposé.

Selon un exemple, le dépôt d'oxyde est effectué par centrifugation.

Selon un exemple, le substrat porte une pluralité de motifs de transistors.

Selon un exemple, un sous-ensemble de la pluralité de motifs de transistors est masqué avant la formation de la couche métallique de sorte à éviter la formation de régions supraconductrices dans les grilles des motifs de transistors dudit sous-ensemble. Cela permet de co-intégrer des dispositifs quantiques avec des transistors, par exemple des transistors CMOS FDSOI, sur un même substrat.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, la forme ou la nature des régions source et drain illustrées sur les figures peuvent être combinés de manière à former un autre mode de réalisation qui n'est pas nécessairement illustré ou décrit. Un tel mode de réalisation n'est évidemment pas exclu de l'invention.

Il est précisé que, dans le cadre de la présente invention, le terme « sur », « surmonte », « recouvre » ou « sous-jacent » ou leurs équivalents ne signifient pas forcément « au contact de ». Ainsi par exemple, un masque dur sur une grille ne signifie pas obligatoirement que le masque dur et la grille sont directement au contact l'un de l'autre, mais cela signifie que le masque dur recouvre au moins partiellement la grille en étant soit directement à son contact soit en étant séparé d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant uniquement ce matériau M, ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stoechiométrique (SiN), ou du nitrure de silicium stoechiométrique (Si3N4), ou encore un oxy-nitrure de silicium (SiON).

En général, mais non limitativement, un espaceur forme une bague autour de la grille, avec un contour fermé ; la description d'un espaceur s'entend de préférence de cet espaceur unique autour de la grille ; cependant, les dessins d'illustration en coupe, généralement selon un plan parallèle à la direction longitudinale du canal, montrent deux parties d'espaceur de part et d'autre des flancs de la grille. Par extension, ces deux parties d'espaceur sont souvent désignées par « les espaceurs ». Cette dernière terminologie peut éventuellement être adoptée dans cette demande. Par ailleurs, l'invention s'étend aux modes de réalisation dans lesquels au moins deux espaceurs discontinus recouvrent un motif de grille.

La présente invention permet notamment la fabrication d'au moins un dispositif quantique ou d'une pluralité de dispositifs quantiques sur un substrat. Ce substrat peut être massif ou « bulk » selon la terminologie anglo-saxonne, ou encore de type semiconducteur sur isolant, par exemple un substrat silicium sur isolant SOI (acronyme de l'anglais « silicon on insulator ») ou un substrat germanium sur isolant GeOI (acronyme de l'anglais « germanium on insulator »).

L'invention peut également être mise en oeuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

En particulier, l'étape de formation de la couche de protection peut survenir en partie lors de la fin de l'étape de fourniture du motif de transistor, de sorte que ces deux étapes sont en partie confondues. C'est par exemple le cas lorsqu'un plasma en chimie HBr/O2 est mis en oeuvre pour graver et former le motif de transistor. Ce plasma peut être prolongé, en variant de préférence les conditions dudit plasma, de façon à former la couche de protection.

Le terme « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Les termes « motif de grille », « empilement de grille », « grille » sont employés en synonymes.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, on parlera préférentiellement d'épaisseur pour une couche, de hauteur pour un dispositif (grille par exemple) et de profondeur pour une cavité ou une gravure. L'épaisseur est prise selon une direction normale au plan d'extension principale de la couche, la hauteur et la profondeur sont prises selon une direction normale au plan de base du substrat. Le plan d'extension principale de la couche, respectivement le plan de base du substrat, est généralement parallèle à une face inférieure ou une face supérieure de cette couche, respectivement de ce substrat.

Dans la présente demande de brevet, un repère de préférence orthonormé formé par les axes x, y, z est représenté sur les dessins d'accompagnement. Le substrat, plus précisément sa face inférieure et/ou sa face supérieure, s'étendent dans le plan basal xy.

Dans la suite, la longueur est prise selon la direction portée par l'axe x, dit axe longitudinal, la largeur est prise selon la direction portée par l'axe y.

Un élément situé « à l'aplomb » ou « au droit d'» un autre élément signifie que ces deux éléments sont situés tous deux sur une même ligne perpendiculaire au plan basal, soit sur une même ligne orientée selon l'axe z sur les figures.

On entend par « horizontale » une orientation parallèle à un plan xy. On entend par « verticale » une orientation parallèle à l'axe z.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

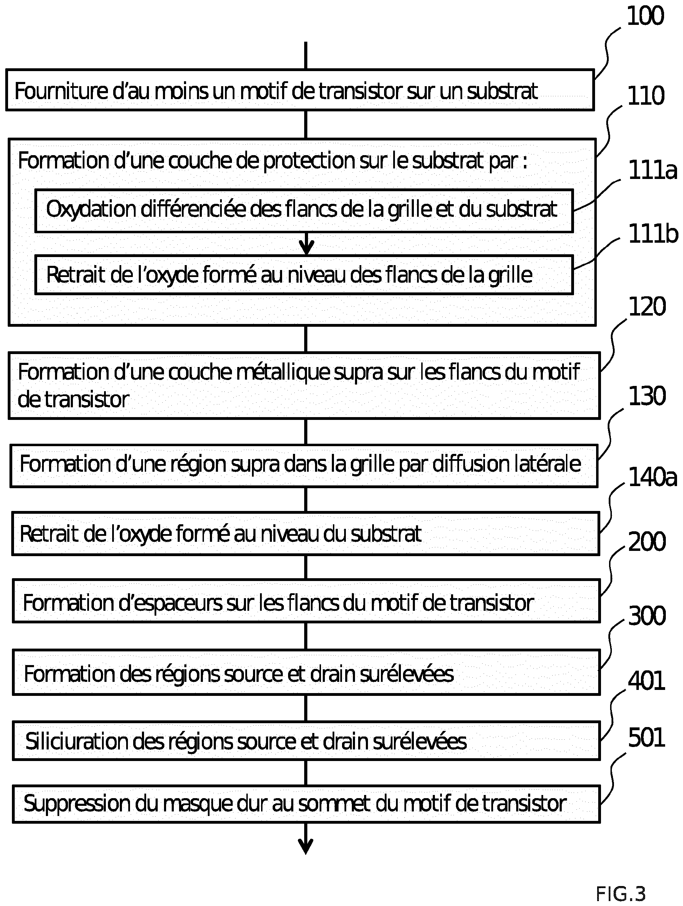

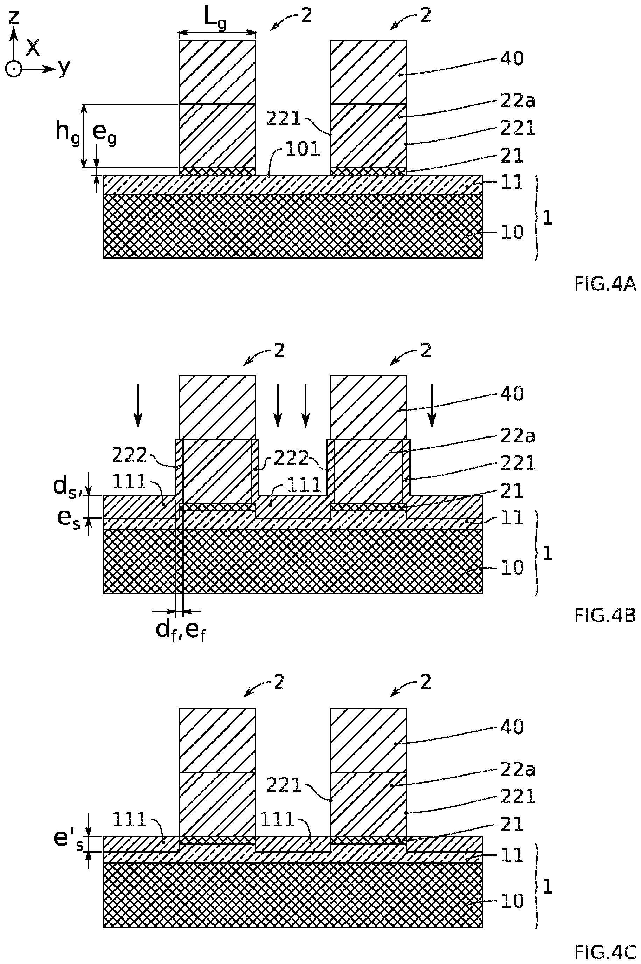

Un premier mode de réalisation du procédé est illustré aux figures 3 et 4A-4J. Ce premier mode de réalisation permet de former un dispositif quantique à au moins deux qubits, ces qubits étant des qubits de spin d'électron ou des qubits supraconducteurs.

Deux motifs de transistors 2 comprenant chacun un diélectrique de grille 21, une grille 22a et un masque dur 40 en empilement sur un substrat 1 sont fournis 100 (figure 4A). Le substrat 1 est typiquement ici un substrat SOI comprenant une région active 11 sur un oxyde enterré 10. Le diélectrique de grille 21 est typiquement à base de dioxyde de silicium SiO2, ou à base d'un matériau à haute constante diélectrique. Le diélectrique de grille 21 présente typiquement une épaisseur e_{g} comprise entre 1 nm et 5 nm. La grille 22a est typiquement à base de silicium polycristallin (polySi). La grille 22a présente typiquement une largeur L_{g} inférieure à 25 nm et une hauteur h_{g} comprise entre 20 nm et 150 nm. Le masque dur 40 est typiquement à base de nitrure de silicium SiN ou de SiO2.

Selon un autre mode de réalisation, le dispositif est réalisé sur un substrat en silicium massif. Dans ce cas, une étape d'introduction de dopant peut être prévue pour assurer un confinement de l'électron, et/ou des matériaux diélectriques, autre que l'oxyde de silicium, peuvent être prévus. Ces diélectriques sont à base, par exemple, de nitrure ou d'alumine.

La fourniture 100 des deux motifs de transistors 2 correspond ici à la formation de ces motifs de transistors 2. En particulier, les grilles 22a sont gravées par gravure plasma conventionnelle, par exemple à l'aide d'un plasma en chimie HBr/O2. A l'issue de cette gravure, la formation 110 d'une couche de protection 111 (figure 4B) au niveau de la face avant 101 du substrat 1 peut se faire à partir d'une étape de surgravure directement successive à la gravure des grilles 22a. Cette étape de surgravure vise à réaliser une oxydation différenciée 111a des flancs 221 et de la face avant 101.

En particulier, les flancs 221 de chaque grille 22a sont oxydés sur une épaisseur e_{f} pour former l'oxyde 222 (figure 4B). La face avant est oxydée sur une épaisseur eₛ pour former l'oxyde 111 (figure 4B). L'oxydation différenciée 111a est configurée de façon à ce que l'épaisseur e_{f} de l'oxyde 222 soit strictement inférieure, par exemple au moins 20% inférieure et de préférence au moins 50% inférieure, à l'épaisseur eₛ de l'oxyde 111. L'épaisseur e_{f} de l'oxyde 222 peut être comprise entre 1 nm et 4 nm. L'épaisseur eₛ de l'oxyde 111 peut être comprise entre 3 nm et 10 nm.

Cette étape de surgravure peut se faire à l'aide d'un plasma à base d'hydrogène et d'un plasma à base d'oxygène. Selon un exemple, le plasma en chimie HBr/O2 utilisé pour graver les grilles 22a est adapté pour oxyder de façon différenciée les flancs 221 et la face avant 101 en fin de gravure des grilles 22a. Par exemple, le mélange HBr/O2 est de 40:1 (par exemple 200 sccm HBr pour 5 sccm O2). La pression est inférieure à 6.7 Pa (50 mTorr), de préférence inférieure à 1.3 Pa (10 mTorr), par exemple 0.8 Pa (6 mTorr). La puissance source est supérieure à 200 W de préférence supérieure à 400 W (typiquement 500 W). La tension du bias est supérieure à 50 V, de préférence supérieure à 60 V (typiquement 80 V). La température du substrat est comprise entre 50°C et 70°C, de préférence de l'ordre de 60°C.

Selon un autre exemple, l'étape de surgravure est réalisée séquentiellement par un premier plasma à base d'hydrogène, par exemple à base de dihydrogène H2 ou d'ammoniac NH3, suivi d'un deuxième plasma à base d'oxygène O2. Le premier plasma permet ici de modifier à la fois le matériau de la couche active 11 sur une profondeur dₛ à partir de la face avant 101, et le matériau de la grille 22a sur une largeur d_{f} à partir des flancs 221. Les portions modifiées par ce premier plasma ne sont pas gravées. Ce premier plasma est configuré de façon à ce que la largeur d_{f} soit strictement inférieure, par exemple au moins 20% inférieure et de préférence au moins 50% inférieure, à la profondeur dₛ. La largeur d_{f} peut être comprise entre 1 nm et 4 nm. La profondeur dₛ peut être comprise entre 3 nm et 10 nm.

Le deuxième plasma permet d'oxyder préférentiellement les portions de couche active 11 et de grille 22a modifiées par le premier plasma. Cela permet de former l'oxyde 111 d'épaisseur eₛ et l'oxyde 222 d'épaisseur e_{f}. De façon connue, l'oxyde formé par oxydation du silicium peut être plus volumineux que le silicium consommé lors de l'oxydation. Ainsi, l'oxyde 111 peut typiquement s'étendre sous la face avant 101 et au-dessus de la face avant 101, de sorte que la profondeur dₛ n'est pas nécessairement égale à l'épaisseur eₛ.

A l'issue de l'étape de surgravure, un oxyde 222 fin est formé sur les flancs 221 de la grille 22a et un oxyde 111 épais est formé en face avant 101 de la couche active 11. L'étape suivante consiste à retirer 111b l'oxyde 222 fin sur les flancs 221 de la grille 22a (figure 4C). Ce retrait 111b peut se faire par gravure humide, par exemple à base d'acide fluorhydrique dilué dHF (concentration en HF de l'ordre de 0,1% à 1%). Selon une possibilité, ce retrait 111b se fait par un procédé de type SiCoNi^{™}, qui comprend typiquement un plasma délocalisé à base d'un mélange NF3/NH3 suivi d'un recuit de sublimation. Après retrait 111b, une partie de l'oxyde 111 sur la face avant, est conservée et présente une épaisseur e'ₛ < eₛ. Cette partie d'oxyde 111 forme la couche de protection 111 d'épaisseur e'ₛ (figure 4C). L'épaisseur e'ₛ est supérieure ou égale à 2 nm.

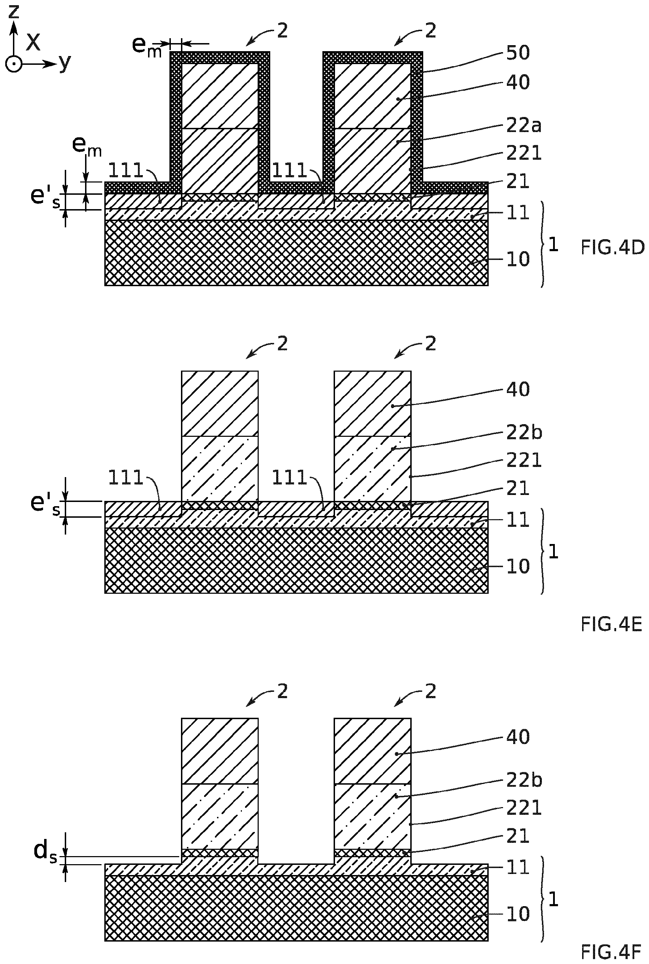

Après retrait 111b, les flancs 221 de la grille 22a sont à nouveau exposés. Un nettoyage des flancs 221 peut être effectué, par exemple par plasma d'argon ou d'hélium, avant dépôt d'une couche métallique 50. La couche métallique 50 peut être déposée de façon conforme sur les motifs de transistors 2 et sur la couche de protection 111 (figure 4D). La couche métallique 50 couvre notamment les flancs 221. Cette couche métallique 50 comprend au moins un élément supraconducteur, par exemple pris parmi le cobalt, le platine ou le vanadium. Elle présente une épaisseur eₘ. Cette épaisseur eₘ est de préférence choisie de façon à ce que toute la grille 22a soit transformée en une région supraconductrice à l'issue de l'étape suivante de diffusion latérale. En particulier, pour une grille 22a en polySi, le siliciure supraconducteur formé à partir de la diffusion latérale dans la grille 22a des éléments supraconducteurs de la couche métallique 50, par exemple le siliciure de cobalt CoSi2, le siliciure de platine PtSi, le siliciure de vanadium V3Si, présente une largeur Lₛᵤₚᵣₐ proportionnelle à la largeur L_{Si} de polySi consommé lors de la transformation, tel que Lₛᵤₚᵣₐ = α.L_{Si}, avec 1,5 ≤ α ≤ 2,5. Comme la diffusion s'effectue à partir de chacun des flancs 221 de la grille 22a, la largeur Lₛᵤₚᵣₐ requise pour transformer la grille 22a en région supraconductrice est égale à L_{g}/2. Dès lors, une épaisseur eₘ de couche métallique 50 supérieure ou égale à la largeur L_{Si} de polySi consommé lors de la transformation permet de siliciurer la grille 22a sur toute sa largeur L_{g}. On choisira donc de préférence eₘ ≥ L_{g}/2α, soit eₘ ≥ L_{g}/5.

La formation 120 de la région supraconductrice 22b au sein de la grille 22a se fait par diffusion latérale des espèces métalliques à partir des flancs 221, c'est-à-dire principalement selon y. Cette diffusion latérale est de préférence configurée de façon à ce que la région supraconductrice 22b soit formée sur toute la largeur L_{g} de la grille 22a (figure 4E). Typiquement deux fronts de diffusion se développent depuis les deux flancs respectifs de la grille 22a. Ces fronts de diffusion sont sensiblement verticaux et progressent en direction du plan médian xz de la grille 22a. La grille 22a est totalement transformée en région supraconductrice 22b lorsque les fronts se rejoignent au niveau de ce plan médian xz. De façon préférée, la présence du masque dur 40 empêche avantageusement une diffusion des espèces métalliques à partir du sommet de la grille 22a. Cela évite qu'un troisième front de diffusion se développe depuis le sommet. La qualité cristalline de la région supraconductrice 22b formée par jonction latérale de deux fronts de diffusion est meilleure que la qualité cristalline d'une région supraconductrice 22b formée par jonction de trois fronts. Ce dernier mode de réalisation à trois fronts de diffusion, quoique plus compliqué à mettre en oeuvre, reste néanmoins possible. La diffusion des espèces métalliques au sein de la grille 22a se fait typiquement par recuit thermique, par exemple à une température de 400 à 800°C. Les conditions de diffusion dépendent typiquement de l'espèce métallique choisie et de sa réactivité avec le silicium. Des exemples sont fournis dans le tableau présenté plus haut.

Avantageusement, la couche de protection 111 évite que les espèces métalliques diffusent dans la couche active 11. Après formation 130 de la région supraconductrice 22b, les résidus métalliques sont de préférence nettoyés, par exemple à l'aide d'une solution à base d'eau oxygénée H2O2 comme un Caro (H₂O₂:H₂SO4), de l'eau régal (HCI:HNO3) et/ou un SC1 (H₂O:H₂O₂:NH₄OH).

La couche de protection 111 peut ensuite être retirée 140a de façon à exposer la couche active 11 (figure 4F). Ce retrait 140a peut se faire par gravure humide, par exemple à base d'acide fluorhydrique HF. Le retrait 140a de cette couche de protection 111 se fait avant l'étape d'épitaxie 300 des régions source et drain. Ce retrait peut donc être effectué directement après formation 130 de la région supraconductrice 22b, ou ultérieurement, par exemple après formation 200 des espaceurs. Cette dernière possibilité peut notamment améliorer la qualité d'interface entre la couche active 11 et le futur espaceur 20.

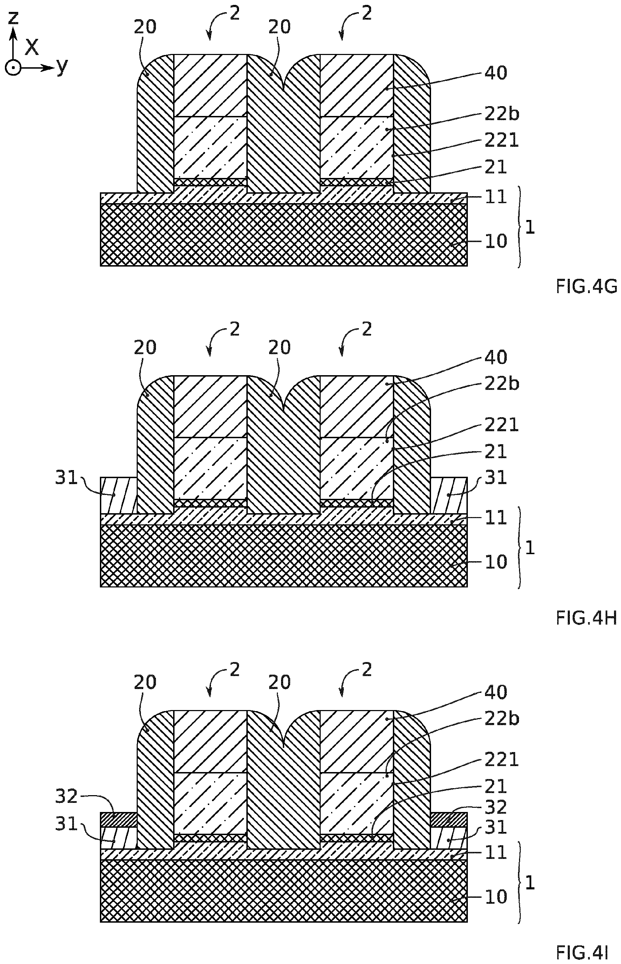

Comme illustré à la figure 4G, le ou les espaceurs 20 sont formés 200 de part et d'autre des motifs de grille. La formation d'espaceurs 20 à base de SiN est une étape standard parfaitement connue. Les régions 31 de source et de drain sont ensuite formées 300 autour des espaceurs 20 (figure 4H) extérieurs. Ces régions 31 sont typiquement formées par épitaxie selon z à partir des zones exposées de la couche active 11. Cela permet d'obtenir de façon connue des régions 31 source et drain surélevées, encore appelées RSD (pour Raised Source Drain).

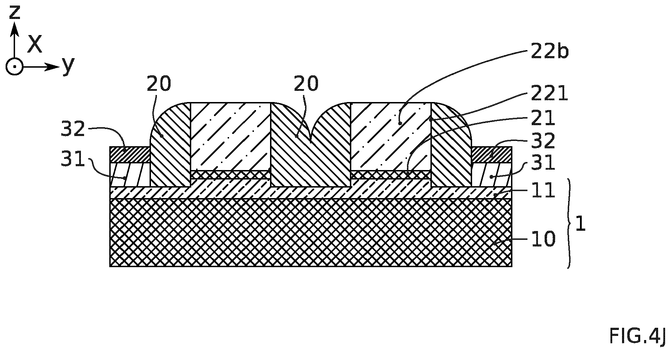

Une siliciuration 401 standard des régions 31 source et drain peut ensuite être effectuée pour former des portions siliciurées 32 (figure 4I). A ce stade, le masque dur 40 est conservé au sommet de la région supraconductrice 22b de façon à éviter une siliciuration supplémentaire de la région supraconductrice 22b. Le masque dur 40 peut être retiré 501 après siliciuration des régions 31 de source et de drain, de façon à exposer le sommet de la région supraconductrice 22b, comme illustré à la figure 4J. Un dispositif quantique à deux qubits comprenant au moins deux régions supraconductrices 22b est ainsi avantageusement formé.

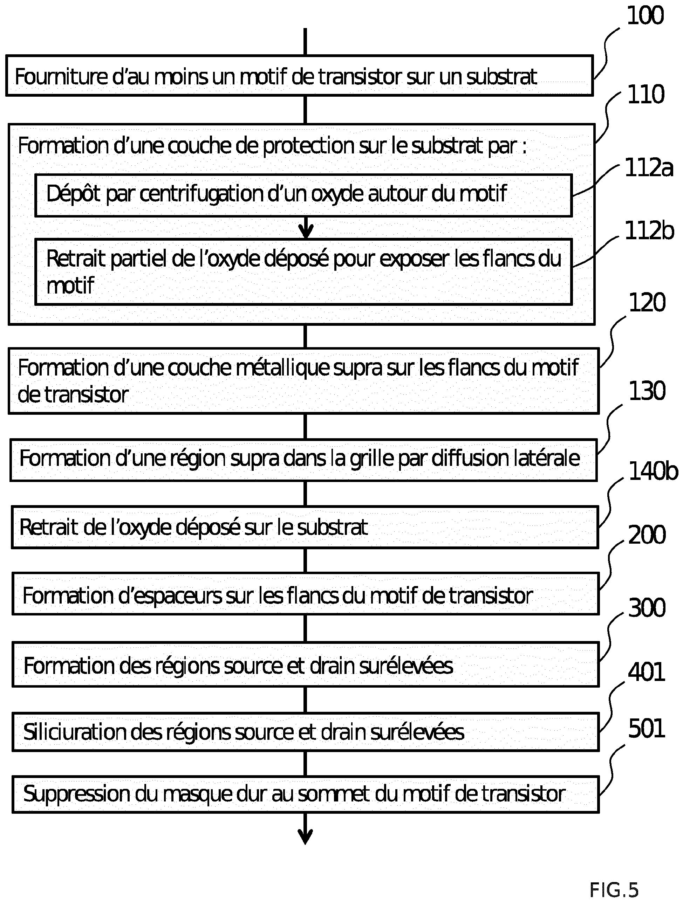

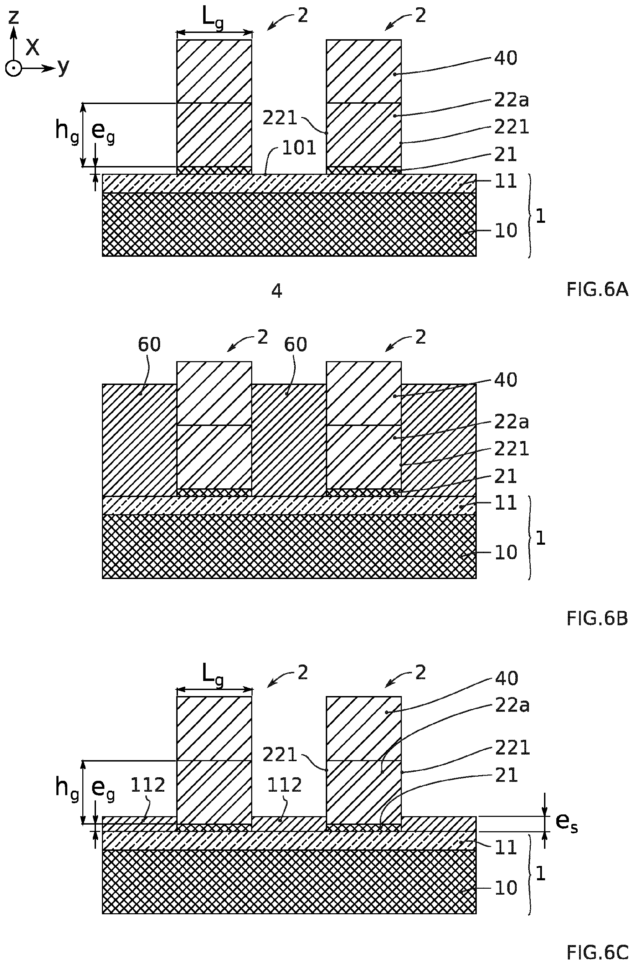

Un deuxième mode de réalisation du procédé est illustré aux figures 5 et 6A-6J. Ce deuxième mode de réalisation permet également de former un dispositif quantique à deux qubits, ces qubits étant des qubits de spin d'électron ou des qubits supraconducteurs. Dans ce mode de réalisation, la formation 110 de la couche de protection se distingue du précédent mode de réalisation. Seules les caractéristiques différentes du premier mode de réalisation sont décrites ci-après, les autres caractéristiques non décrites étant réputées identiques.

Deux motifs de transistors 2 comprenant chacun un diélectrique de grille 21, une grille 22a et un masque dur 40 en empilement sur un substrat 1 sont ici fournis 100 (figure 6A) indépendamment de l'étape de formation 110 de la couche de protection.

La formation 110 de la couche de protection commence ici après la gravure des grilles 22a. Cette formation 110 se fait typiquement en deux étapes : une couche d'oxyde 60 est d'abord formée entre les motifs de transistors 2, sur la face avant 101, comme illustré à la figure 6B. Cette couche d'oxyde 60, par exemple un oxyde fluide de type SoG (acronyme de Spin on Glass), peut être déposée 112a par centrifugation. Les conditions de dépôt par centrifugation peuvent être choisies en fonction de la densité de motifs de transistors 2 sur le substrat, du facteur de forme hauteur/largeur des espaces à remplir, et de l'épaisseur d'oxyde 60 souhaitée. de façon connue on adaptera la vitesse de la tournette pour un dépôt homogène sur toute la plaque ainsi que le temps de procédé pour contrôler l'épaisseur déposée. Un recuit permet ensuite de solidifier la couche d'oxyde 60.

Un retrait partiel 112b de cette couche d'oxyde 60 est ensuite effectué de façon à former une couche de protection 112 d'épaisseur eₛ (figure 6C). Ce retrait 112b est de préférence configuré de manière à ce que l'épaisseur eₛ de la couche de protection 112 soit supérieure à 2 nm et/ou supérieur à l'épaisseur e_{g} du diélectrique de grille 21. Cela permet d'éviter toute diffusion parasite ultérieure de métal dans la couche active 11, notamment au niveau du pied des motifs de transistor, à l'aplomb des flancs 221.

Ce retrait partiel 112b peut être effectué par gravure humide à base de HF ou par gravure plasma en chimie fluorocarbonée. Une solution de HF diluée de l'ordre de 0,1% à 1% est de préférence utilisée. Cela permet d'obtenir une bonne sélectivité de gravure vis-à-vis de la grille 22a et/ou du masque dur 40. Le retrait 112b peut également se faire par un procédé de type SiCoNi^{™}, qui comprend typiquement un plasma délocalisé à base d'un mélange NF3/NH3 suivi d'un recuit de sublimation.

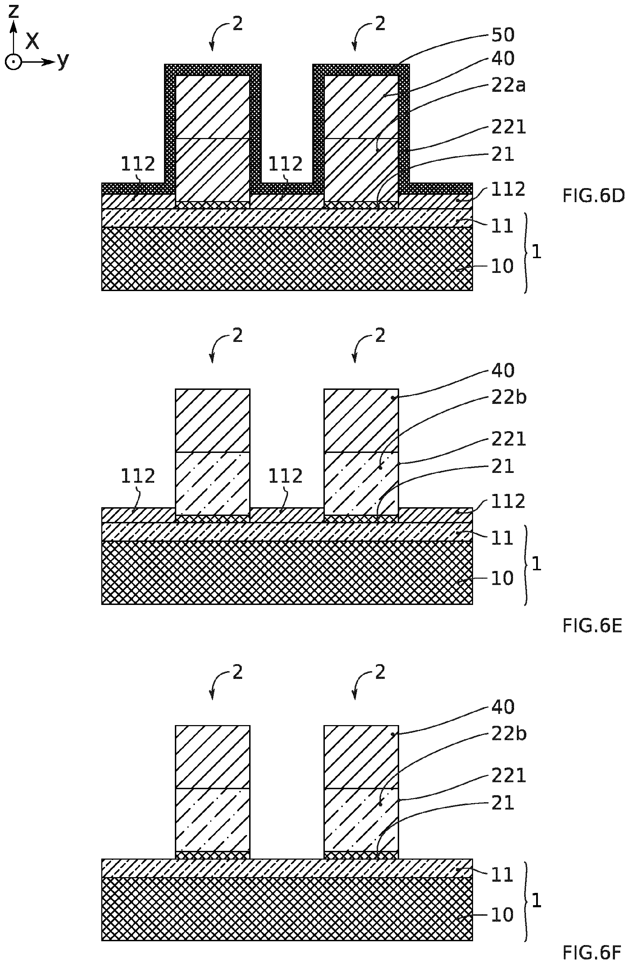

Les flancs 221 de la grille 22a sont en partie exposés à l'issue de ce retrait 112b, sur au moins 80% de leur hauteur h_{g}, et de préférence sur au moins 90% de leur hauteur h_{g}. La couche métallique 50 est ensuite déposée 120 sur les flancs 221 exposés des motifs de transistor, comme illustré à la figure 6D. La diffusion latérale des éléments supraconducteurs se fait alors à partir des flancs 221 couverts par la couche métallique 50, de manière à former 130 la région supraconductrice 22b, comme précédemment (figure 6E).

Après formation 130 de la région supraconductrice 22b, les résidus métalliques sont de préférence nettoyés, puis la couche de protection 112 est retirée 140b de façon à exposer la face avant 101 de la couche active 11 (figure 6F). Ce deuxième mode de réalisation permet ainsi de conserver une épaisseur de couche active 11 sensiblement constante. Cela permet de conserver une épaisseur de couche active suffisante, typiquement supérieure à 3nm. Une telle épaisseur de couche active permet d'éviter des phénomènes d'agglomération ou de mise en boule de la couche active lors de procédés ultérieurs à hautes températures, par exemple lors de l'épitaxie des sources et drains surélevés RSD.

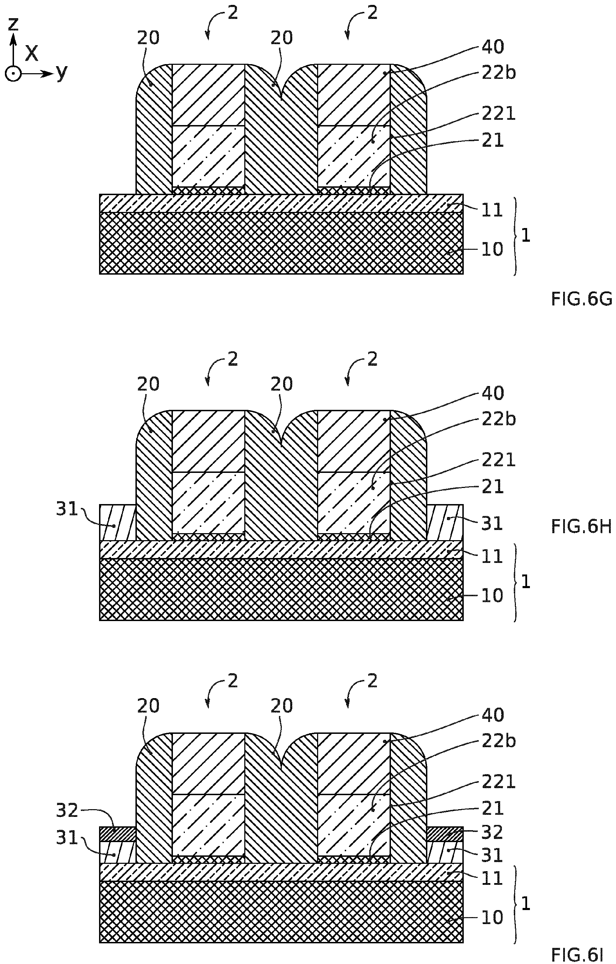

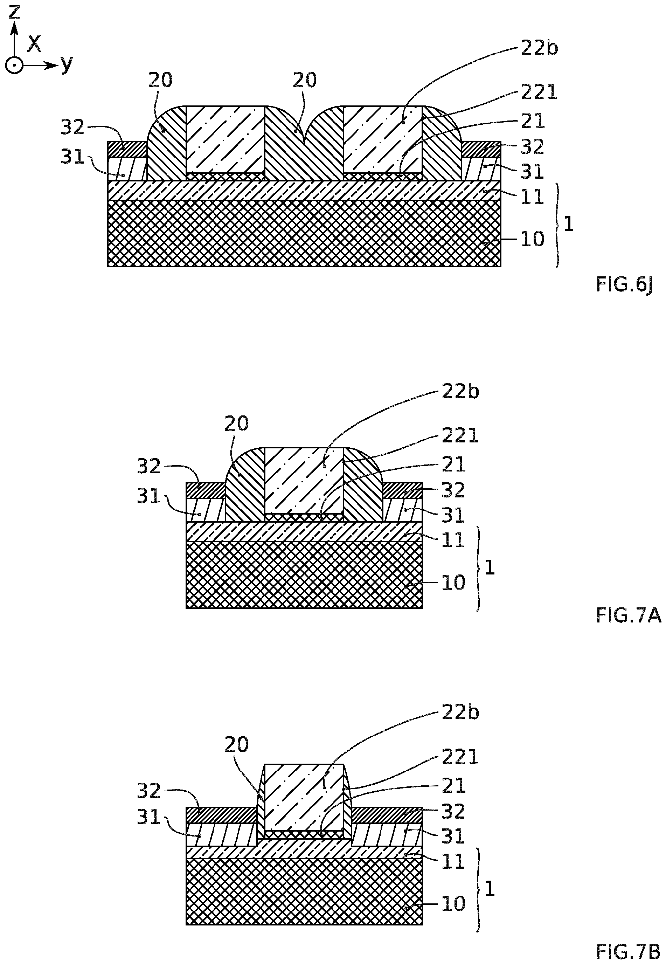

Les étapes suivantes de formation 200 des espaceurs 20 (figure 6G), de formation 300 et de siliciuration 401 des régions 31 source et drain (figures 6H et 6I) sont similaires au premier mode de réalisation décrit précédemment. Un dispositif quantique à deux qubits comprenant deux régions supraconductrices 22b est ainsi avantageusement formé (figure 6J).

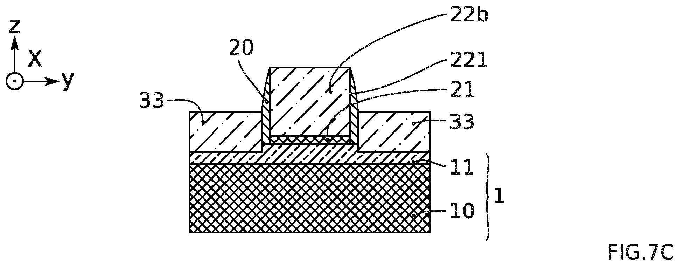

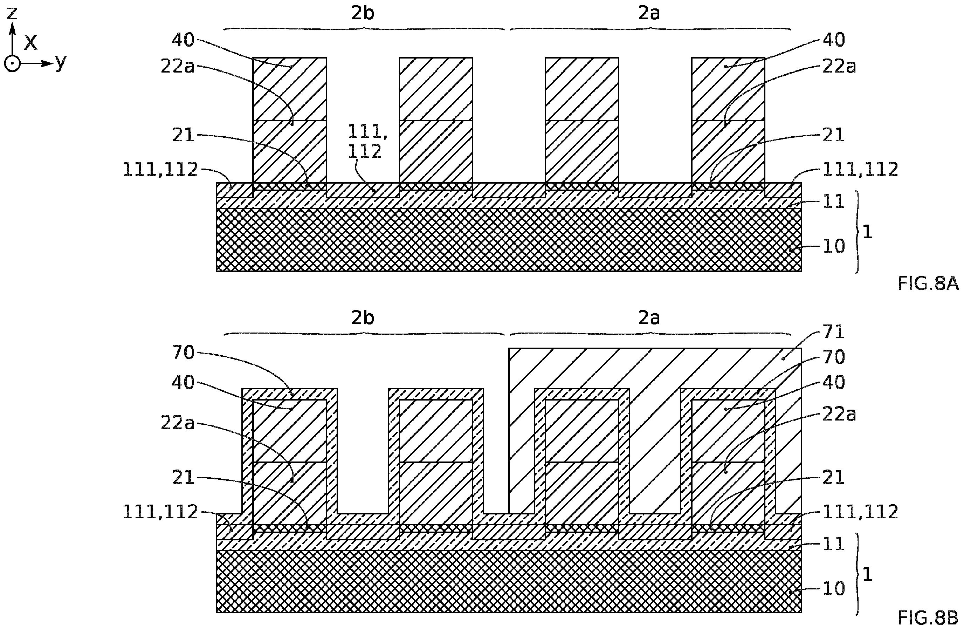

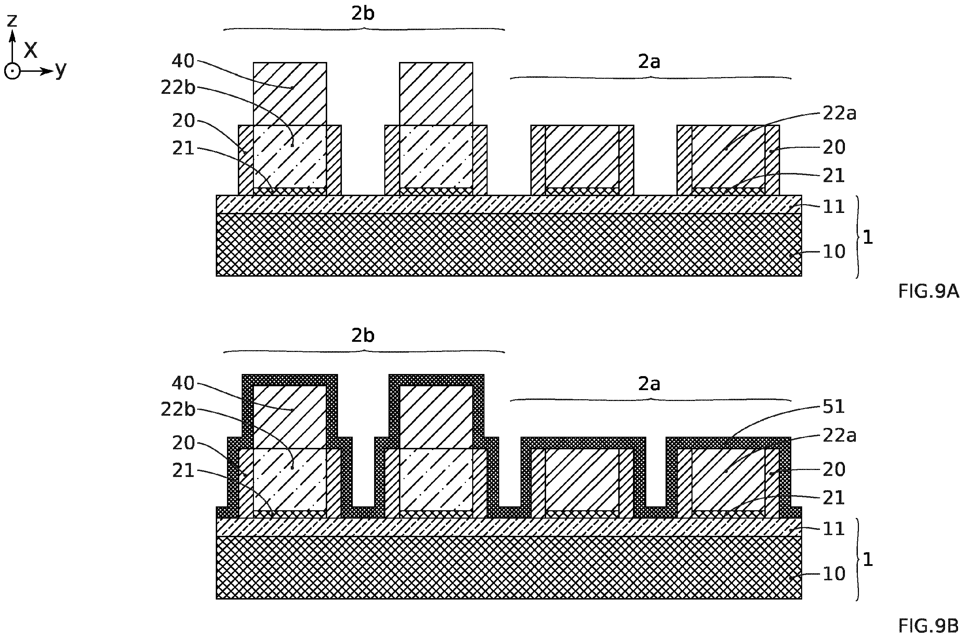

D'autres modes de réalisation sont également possibles. Les figures 7A, 7B, 7C ainsi que les figures 8A-8F et 9A-9D illustrent de façon non limitative certains de ces modes de réalisation. En particulier, il est parfaitement possible d'envisager la réalisation d'un dispositif quantique comprenant une seule région supraconductrice 22b (figure 7A). Alternativement ou en combinaison, la largeur des espaceurs 20 peut également être réduite, de façon à rapprocher les régions 31 source et drain du canal (classiquement situé sous la région supraconductrice 22b). Alternativement ou en combinaison, le siliciure 32 standard des régions 31 source et drain peut être remplacé par un siliciure 33 supraconducteur, par exemple de même nature que la région supraconductrice 22b (figure 7C). Cela peut être intéressant pour certaines applications, par exemple pour des applications transmon (qubit de charge supraconducteur), gatemon (transmon à polarisation variable) ou encore JoFET (FET avec des régions source et drain supraconductrices).

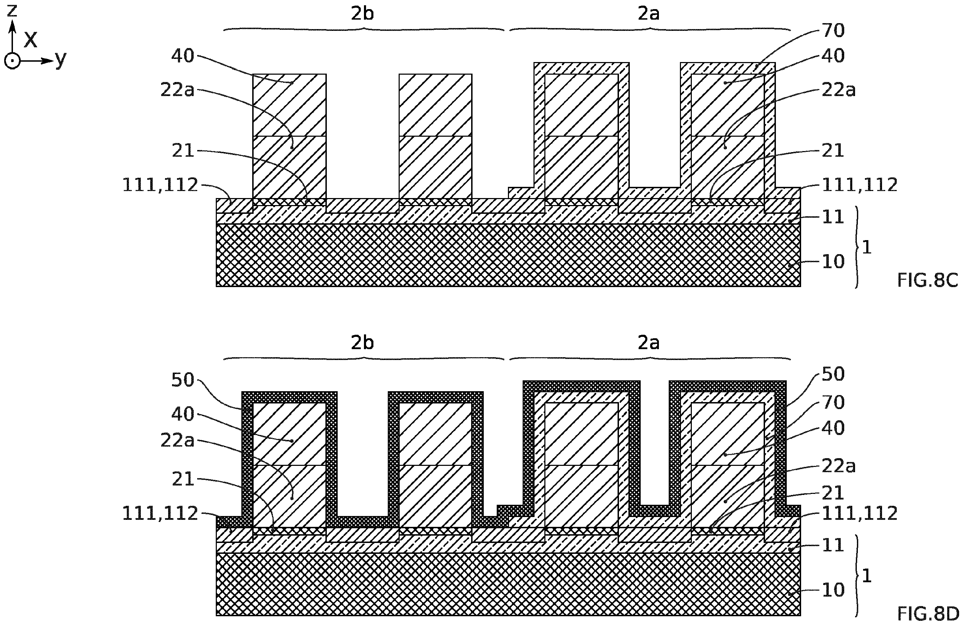

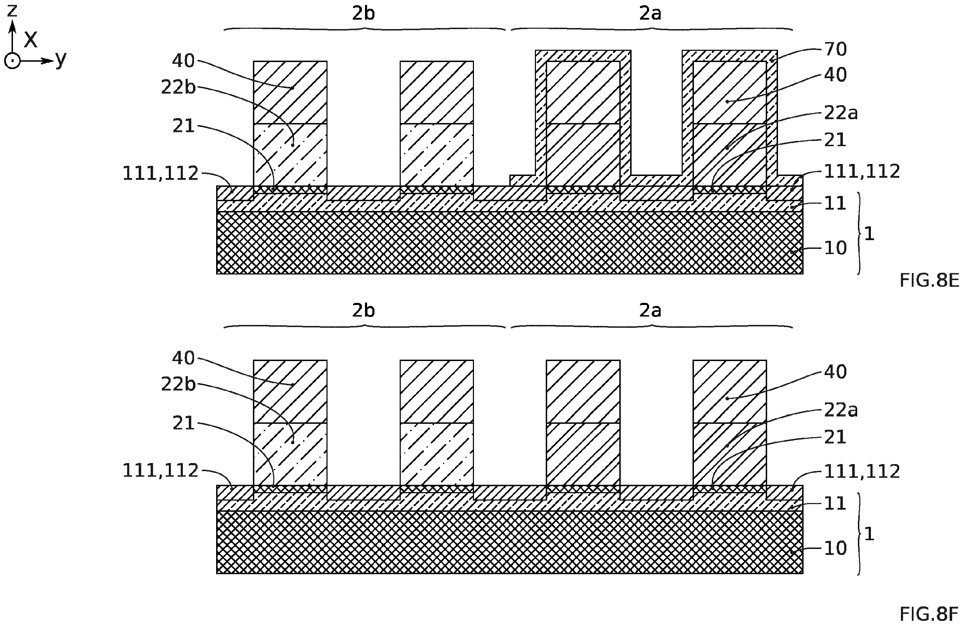

Les figures 8A à 8F illustrent une partie du procédé permettant de co-intégrer sur un même substrat 1 des transistors MOSFET FDSOI conventionnels et des dispositifs quantiques à grille supraconductrice. Cela peut être réalisé en masquant par une couche de masquage 70 une partie des motifs de transistors 2 avant la formation 120 de la couche métallique 50. Cela permet d'éviter la formation 130 de régions supraconductrices 22b dans les grilles 22a des motifs de transistors 2 masqués. Selon un exemple, après formation 110 de la couche de protection 111, 112 (figure 8A), une couche de masquage 70 à base de SiO2 ou de préférence à base de SiN de quelques nanomètres d'épaisseur, par exemple 2 nm à 3 nm, est déposée de façon conforme sur l'ensemble des motifs de transistors 2. Une étape de photolithographie classique permet de masquer une partie des motifs de transistors 2 par une résine 71 (figure 8B). La couche de masquage 70 est alors retirée sur les motifs de transistors 2 non masqués, par exemple par voie humide à partir d'une solution de HF ou par plasma isotrope. La résine 71 est ensuite retirée, par voie humide ou par plasma O2, de façon à obtenir un premier ensemble 2a de motifs de transistors 2 avec couche de masquage 70, et un deuxième ensemble 2b de motifs de transistors 2 sans couche de masquage 70 (figure 8C). La couche métallique 50 peut ensuite être déposée de façon conforme sur les premier et deuxième ensembles 2a, 2b, comme illustré à la figure 8D. La formation 130 des régions supraconductrices 22b se fait alors uniquement au sein des grilles 22a du deuxième ensemble 2b de motifs de transistors 2, comme illustré à la figure 8E. La couche de masquage 70 empêche avantageusement la diffusion latérale des éléments supraconducteurs au sein des grilles 22a du premier ensemble 2a de motifs de transistors 2. Les grilles 22a du premier ensemble 2a de motifs de transistors 2 sont ainsi préservées. La couche de masquage 70 peut ensuite être retirée, comme illustré à la figure 8F. Ce retrait peut se faire par gravure humide à base d'une solution d'acide phosphorique H3PO4 si la couche de masquage 70 est à base de SiN. Une telle gravure présente notamment une bonne sélectivité vis-à-vis de l'oxyde 111, 112. Alternativement, une gravure plasma isotrope peut être effectuée pour retirer la couche de masquage 70. Une gravure humide à base d'une solution HF peut alternativement être effectuée si la couche de masquage 70 est à base de SiO2.

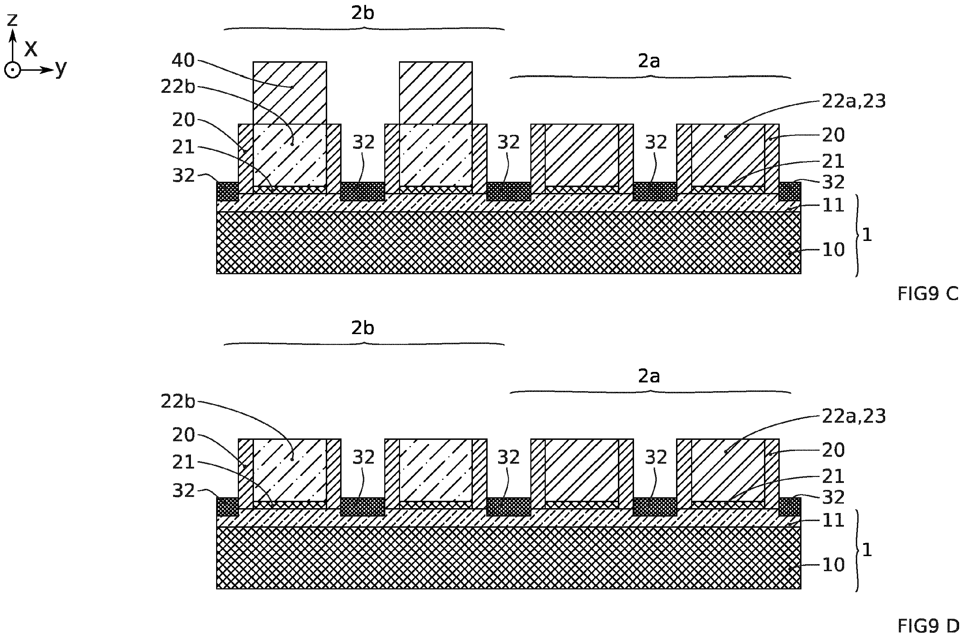

Les figures 9A à 9D illustrent une partie du procédé permettant de siliciurer les grilles 22a des transistors MOSFET FDSOI conventionnels co-intégrés avec des dispositifs quantiques à grille supraconductrice. La couche active 11 illustrée ici est d'épaisseur constante. Les régions source et drain peuvent être ici formées directement dans la couche active 11. Cette partie de procédé peut également être mise en oeuvre avec des régions source et drain surélevées, par exemple formées sur une couche active 11 d'épaisseur non constante, tel que décrit et illustré précédemment. Après formation des régions supraconductrices 22b dans les motifs de transistors 2 de l'ensemble 2b, le masque dur 40 est retiré du sommet des grilles 22a de l'ensemble 2a, et conservé sur le sommet des grilles supraconductrices 22b de l'ensemble 2b (figure 9A). Une couche métallique 51, par exemple à base de nickel ou de titane, peut ensuite être déposée de façon conforme sur les motifs des ensembles 2a, 2b (figure 9B). Une siliciuration peut alors être effectuée, typiquement par recuit thermique, de façon à siliciurer partiellement ou totalement les grilles 22a, 23 de l'ensemble 2a (figure 9C). Cette siliciuration n'affecte pas les grilles supraconductrices 22b de l'ensemble 2b, qui sont protégées par les espaceurs 20 et les masques durs 40. Cette siliciuration peut également permettre de former des portions 32 siliciurées au niveau des régions source et drain. Après retrait des masques durs 40, des dispositifs quantiques à grille supraconductrice 22b et des transistors MOSFET FDSOI à grille siliciurée 23 non supraconductrice sont co-intégrés sur un même substrat 1 (figure 9D).

## Revendications

1. Procédé de réalisation d'un dispositif quantique comprenant les étapes suivantes :
- Fournir (100) un substrat (1) présentant une face avant (101) et portant au moins un motif de transistor (2) sur sa face avant (101),
Ledit motif de transistor (2) comprenant, en empilement :
• un diélectrique de grille (21) sur la face avant (101) du substrat (1),
• une grille (22a) sur le diélectrique de grille (21), ladite grille (22a) présentant un sommet et des flancs (221),
- Former (110) une couche de protection (111, 112) au niveau de la face avant (101) du substrat (1), ladite couche de protection (111, 112) étant configurée pour empêcher une diffusion d'au moins une espèce métallique dans le substrat (1),
- Former (120) une couche métallique (50) à base d'au moins une espèce métallique au moins sur les flancs (221) de la grille (22a),
- Former (130) une région (22b) supraconductrice dans la grille (22a), par diffusion latérale de l'au moins une espèce métallique à partir des flancs (221) de ladite grille (22a).

2. Procédé selon la revendication précédente dans lequel le motif de transistor (2) fourni comprend en outre un masque dur (40) sur le sommet de la grille (22a), ledit masque dur (40) étant configuré pour empêcher une diffusion d'au moins une espèce métallique dans la grille (22a) à partir dudit sommet, de sorte que la formation (130) de la région (22b) supraconductrice se fait uniquement par diffusion latérale à partir des flancs (221) de la grille (22a).

3. Procédé selon l'une quelconque des revendications précédentes dans lequel la couche métallique (50) formée comprend au moins une espèce métallique parmi du cobalt, du platine et du vanadium

4. Procédé selon l'une quelconque des revendications précédentes dans lequel la couche métallique (50) est formée (120) par dépôt conforme de métal sur le motif de transistor (2) et sur la couche de protection (111, 112) en face avant (101) du substrat (1).

5. Procédé selon l'une quelconque des revendications précédentes dans lequel la grille (22a) présente une largeur Lg et la couche métallique (50) formée présente une épaisseur em ≥ Lg/5.

6. Procédé selon l'une quelconque des revendications précédentes dans lequel la diffusion latérale se fait par recuit thermique.

7. Procédé selon l'une quelconque des revendications précédentes dans lequel la couche de protection (111, 112) formée au niveau de la face avant (101) du substrat présente une épaisseur e's supérieure ou égale à 2 nm lors de la formation (130) de la région (22b) supraconductrice.

8. Procédé selon l'une quelconque des revendications précédentes dans lequel la formation (110) de la couche de protection (111) comprend les sous-étapes suivantes :
- Oxyder (111a) de façon différenciée la face avant (101) du substrat (1) et les flancs (221) de la grille (22a), de sorte que l'épaisseur ef d'oxyde (222) formé au niveau des flancs (221) de la grille (22a) soit strictement inférieure à l'épaisseur es d'oxyde (111) formé au niveau de la face avant (101) du substrat (1), tel que ef ≤ k.es avec k ≤ 0,8 et de préférence k ≤ 0,5,
- Retirer (111b) l'oxyde (222) formé au niveau des flancs (221) de la grille (22a), ledit retrait (111b) étant configuré pour conserver au moins en partie l'oxyde (111) formé au niveau de la face avant (101) du substrat (1) de façon à former (110) la couche de protection (111).

9. Procédé selon la revendication précédente dans lequel l'oxydation (111a) différenciée est réalisée à partir d'au moins un plasma comprenant des espèces à base d'oxygène et des espèces à base d'hydrogène.

10. Procédé selon la revendication précédente dans lequel les espèces à base d'hydrogène sont prises parmi le dihydrogène H2, l'ammoniac NH3, l'hydrure de bore HBr.

11. Procédé selon l'une quelconque des revendications 8 à 10 dans lequel le retrait (111b) de l'oxyde (222) formé au niveau des flancs (221) de la grille (22a) se fait par gravure humide.

12. Procédé selon l'une quelconque des revendications 1 à 7 dans lequel la formation (110) de la couche de protection (112) comprend les sous-étapes suivantes :
- Déposer (112a) un oxyde (60) sur la face avant (101) du substrat (1) et sur les flancs (221) de la grille (22a),
- Retirer (112b) en partie l'oxyde (60) déposé de sorte à conserver une couche d'oxyde (112) sur la face avant (101) du substrat (1), ladite couche d'oxyde (112) présentant une épaisseur e's supérieure ou égale à l'épaisseur eg du diélectrique de grille (21) du motif de transistor (2).

13. Procédé selon la revendication précédente dans lequel les flancs (221) de la grille (21a) sont exposés sur au moins 90% de leur hauteur hg, à l'issue du retrait (12b) de l'oxyde (60) déposé.

14. Procédé selon l'une quelconque des deux revendications précédentes dans lequel le dépôt (112a) d'oxyde est effectué par centrifugation.

15. Procédé selon l'une quelconque des revendications précédentes dans lequel le substrat (1) porte une pluralité de motifs de transistors (2) et dans lequel un sous-ensemble de la pluralité de motifs de transistors (2) est masqué avant la formation (120) de la couche métallique (50) de sorte à éviter la formation (130) de régions (22b) supraconductrices dans les grilles (22a) des motifs de transistors (2) dudit sous-ensemble.

## Patentansprüche

1. Verfahren zum Herstellen einer Quantenvorrichtung, das die folgenden Schritte umfasst:
- Bereitstellen (100) eines Substrats (1), das eine Vorderseite (101) aufweist und mindestens ein Transistormuster (2) auf seiner Vorderseite (101) trägt,
wobei das Transistormuster (2) in einem Stapel Folgendes umfasst:
• ein Gate-Dielektrikum (21) auf der Vorderseite (101) des Substrats (1),
• ein Gate (22a) auf dem Gate-Dielektrikum (21), wobei das Gate (22a) eine Oberseite und Seitenwände (221) aufweist,
- Bilden (110) einer Schutzschicht (111, 112) auf Höhe der Vorderseite (101) des Substrats (1), wobei die Schutzschicht (111, 112) so konfiguriert ist, dass sie die Diffusion von mindestens einer Metallart in das Substrat (1) verhindert,
- Bilden (120) einer Metallschicht (50) auf Basis mindestens einer Metallart zumindest auf den Seitenwänden (221) des Gates (22a),
- Bilden (130) eines supraleitenden Bereichs (22b) im Gate (22a) durch seitliche Diffusion der mindestens einen Metallart aus den Seitenwänden (221) des Gates (22a).

2. Verfahren nach dem vorhergehenden Anspruch, wobei das bereitgestellte Transistormuster (2) ferner eine Hartmaske (40) auf der Oberseite des Gates (22a) umfasst, wobei die Hartmaske (40) so konfiguriert ist, dass eine Diffusion mindestens einer Metallart im Gate (22a) von der Oberseite her verhindert, so dass das Bilden (130) des supraleitenden Bereichs (22b) nur durch seitliche Diffusion von den Seitenwänden (221) des Gates (22a) aus erfolgt.

3. Verfahren nach einem der vorhergehenden Ansprüche, wobei die gebildete Metallschicht (50) mindestens eine Metallart ausgewählt aus Kobalt, Platin und Vanadium umfasst.

4. Verfahren nach einem der vorhergehenden Ansprüche, wobei die Metallschicht (50) durch konforme Metallabscheidung auf dem Transistormuster (2) und auf der der Schutzschicht (111, 112) auf der Vorderseite (101) des Substrats (1) gebildet wird (120).

5. Verfahren nach einem der vorhergehenden Ansprüche, wobei das Gate (22a) eine Breite Lg aufweist und die gebildete Metallschicht (50) eine Dicke von em ≥ Lg/5 aufweist.

6. Verfahren nach einem der vorhergehenden Ansprüche, wobei die seitliche Diffusion durch thermisches Glühen erfolgt.

7. Verfahren nach einem der vorhergehenden Ansprüche, wobei die Schutzschicht (111, 112), die auf Höhe der Vorderseite (101) des Substrats gebildet wird, während des Bildens (130) des supraleitenden Bereichs (22b) eine Dicke e's von größer oder gleich 2 nm aufweist.

8. Verfahren nach einem der vorhergehenden Ansprüche, wobei das Bilden (110) der Schutzschicht (111) die folgenden Teilschritte umfasst:
- Oxidieren (111a) der Vorderseite (101) des Substrats (1) und der Seitenwände (221) des Gates (22a) in differenzierter Weise, so dass die Dicke ef des Oxids (222), das an den Seitenwänden (221) des Gates (22a) gebildet wird, strikt geringer als die Dicke es des Oxids (111) ist, das auf Höhe der Vorderseite (101) des Substrats (1) gebildet wird, so dass ef ≤ k.es mit k ≤ 0,8 und vorzugsweise k ≤ 0,5,
- Entfernen (111b) des Oxids (222), das auf Höhe der Seitenwände (221) des Gates (22a) gebildet wird, wobei das Entfernen (111b) so ausgestaltet ist, dass es zumindest einen Teil des Oxids (111), auf Höhe der Vorderseite (101) des Substrats (1) gebildet wird, zurückhält, um so die Schutzschicht (111) zu bilden (110).

9. Verfahren nach dem vorhergehenden Anspruch, wobei die differenzierte Oxidation (111a) unter Verwendung mindestens eines Plasmas durchgeführt wird, das sauerstoffbasierte Arten und wasserstoffbasierte Arten umfasst.

10. Verfahren nach dem vorhergehenden Anspruch, wobei die wasserstoffbasierten Arten ausgewählt sind aus Diwasserstoff H2, Ammoniak NH3 und Borhydrid HBr.

11. Verfahren nach einem der Ansprüche 8 bis 10, wobei das Entfernen (111b) des Oxids (222), das auf Höhe der Seitenwände (221) des Gates (22a) gebildet wird, durch Nassätzen erfolgt.

12. Verfahren nach einem der Ansprüche 1 bis 7, wobei das Bilden (110) der Schutzschicht (112) die folgenden Teilschritte umfasst:
- Abscheiden (112a) eines Oxids (60) auf der Vorderseite (101) des Substrats (1) und auf den Seitenwänden (221) des Gates (22a),
- teilweises Entfernen (112b) des abgeschiedenen Oxids (60), um eine Oxidschicht (112) auf der Vorderseite (101) des Substrats (1) zu bewahren, wobei die Oxidschicht (112) eine Dicke e's aufweist, die größer oder gleich der Dicke eg des Gate-Dielektrikums (21) des Transistormusters (2) ist.

13. Verfahren nach dem vorhergehenden Anspruch, wobei die Seitenwände (221) des Gates (21a) nach dem Entfernen (12b) des abgeschiedenen Oxids (60) über mindestens 90 % ihrer Höhe hg freigelegt sind.

14. Verfahren nach einem der beiden vorhergehenden Ansprüche, wobei das Abscheiden (112a) des Oxids durch Schleudern erfolgt.

15. Verfahren nach einem der vorhergehenden Ansprüche, wobei das Substrat (1) eine Vielzahl von Transistormustern (2) trägt und wobei eine Teilmenge der Vielzahl von Transistormustern (2) vor dem Bilden (120) der Metallschicht (50) maskiert wird, um das Bilden (130) von supraleitenden Bereichen (22b) in den Gates (22a) der Transistormuster (2) der Teilmenge zu verhindern.

## Claims

1. A method for producing a quantum device comprising the following steps:
- Providing (100) a substrate (1) having a front face (101) and carrying at least one transistor pattern (2) on its front face (101),
Said transistor pattern (2) comprising, in a stack:
• a gate dielectric (21) on the front face (101) of the substrate (1),
• a gate (22a) on the gate dielectric (21), said gate (22a) having a top and sides (221),
- Forming (110) a protective layer (111, 112) at the front face (101) of the substrate (1), said protective layer (111, 112) being configured to prevent diffusion of at least one metal species into the substrate (1),
- Forming (120) a metal layer (50) based on at least one metal species at least on the sides (221) of the gate (22a),
- Forming (130) a superconducting region (22b) in the gate (22a), by lateral diffusion of the at least one metal species from the sides (221) of said gate (22a).

2. The method according to the preceding claim wherein the transistor pattern (2) provided further comprises a hard mask (40) on the top of the gate (22a), said hard mask (40) being configured to prevent diffusion of at least one metal species into the gate (22a) from said top, such that the formation (130) of the superconducting region (22b) takes place only by lateral diffusion from the sides (221) of the gate (22a).

3. The method according to any one of the preceding claims, wherein the metal layer (50) formed comprises at least one metal species from cobalt, platinum and vanadium.

4. The method according to any one of the preceding claims, wherein the metal layer (50) is formed (120) by conformal deposition of metal on the transistor pattern (2) and on the protective layer (111, 112) on the front face (101) of the substrate (1).

5. The method according to any one of the preceding claims, wherein the gate (22a) has a width Lg and the formed metal layer (50) has a thickness em≥Lg/5.

6. The method according to any one of the preceding claims, wherein the lateral diffusion is carried out by thermal annealing.

7. The method according to any one of the preceding claims, wherein the protective layer (111, 112) formed at the front face (101) of the substrate has a thickness e's greater than or equal to 2 nm during the formation (130) of the superconducting region (22b).

8. The method according to any one of the preceding claims, wherein the formation (110) of the protective layer (111) comprises the following sub-steps:
- Oxidising (111a) in a differentiated manner the front face (101) of the substrate (1) and the sides (221) of the gate (22a), so that the thickness e_{f} of the oxide (222) formed at the sides (221) of the gate (22a) is strictly less than the thickness es of oxide (111) formed at the front face (101) of the substrate (1), such that ef ≤k.es with k ≤ 0.8 and preferably k ≤ 0.5,
- Removing (111b) the oxide (222) formed at the sides (221) of the gate (22a), said removal (111b) being configured to retain at least part of the oxide (111) formed at the front face (101) of the substrate (1) so as to form (110) the protective layer (111).

9. The method according to the preceding claim, wherein the differentiated oxidation (111a) is carried out from at least one plasma comprising oxygen-based species and hydrogen-based species.

10. The method according to the preceding claim, wherein the hydrogen-based species are taken from dihydrogen H2, ammonia NH3, boron hydride HBr.

11. The method according to any one of claims 8 to 10 wherein the removal (111b) of the oxide (222) formed at the sides (221) of the gate (22a) is done by wet etching.

12. The method according to any one of claims 1 to 7, wherein the formation (110) of the protective layer (112) comprises the following sub-steps:
- Depositing (112a) an oxide (60) on the front face (101) of the substrate (1) and on the sides (221) of the gate (22a),
- Partially removing (112b) the oxide (60) deposited so as to retain an oxide layer (112) on the front face (101) of the substrate (1), said oxide layer (112) having a thickness e's greater than or equal to the thickness eg of the gate dielectric (21) of the transistor pattern (2).

13. The method according to the preceding claim, wherein the sides (221) of the gate (21a) are exposed over at least 90% of their height hg, after removal (12b) of the deposited oxide (60).

14. The method according to any one of the two preceding claims, wherein the deposition (112a) of oxide is carried out by centrifugation.

15. The method according to any one of the preceding claims wherein the substrate (1) carries a plurality of transistor patterns (2) and wherein a subset of the plurality of transistor patterns (2) is masked prior to the formation (120) of the metal layer (50) so as to avoid the formation (130) of superconducting regions (22b) in the gates (22a) of the transistor patterns (2) of said subset.
